# EUROPEAN PATENT APPLICATION

(11) **EP 4 439 676 A1**
(43) Date of publication of application: **02.10.2024**
(21) Application number: 24167319.3
(22) Date of filing: 28.03.2024
(51) Int. Cl.: H01L 29/778, H01L 29/40, H01L 23/31, H01L 29/20, H01L 29/10

(54) **GAN SEMICONDUCTOR POWER TRANSISTORS WITH STEPPED METAL FIELD PLATES AND METHODS OF FABRICATION**

(30) Priority: 31.03.2023 US 202318129457
(71) Applicant: Infineon Technologies Canada Inc., Kanata, Ontario K2V 1C8 (CA)
(72) Inventor: UNNI, Vineet, Kanata, K2T 0C3 (CA); MACELWEE, Thomas, Nepean, K2J1S2 (CA)
(74) Representative: Kraus & Lederer PartGmbB

(57) **Abstract**

A GaN semiconductor power transistor structure with a stepped gate field plate, and a method of fabrication is disclosed. The stepped gate field plate is formed using contact metal and/or interconnect metal. The stepped structure of the gate field plate is defined by dielectric etching to form openings for the stepped gate field plate, and the dielectric thickness under the gate field plate is sized and stepped to shape appropriately the electric field in the region between the gate and drain. The resulting stepped gate field plate structure is less sensitive to limitations of stepped field plates fabricated by a lift-off metal process.

## Description

### TECHNICAL FIELD

This invention relates to Gallium Nitride (GaN) semiconductor power transistors, such as GaN HEMTs (High Electron Mobility Transistors), for high voltage and high current applications.

### BACKGROUND

In a field effect transistor, a field plate may be used to engineer or shape the electric field between electrodes, e.g. in the region around the gate and between the gate and the drain, to reduce the dynamic on-resistance, increase the device breakdown voltage, and improve reliability.

In some device structures, gate metal is used to form a gate metal field plate (GFMP) For example, a stepped GMFP may be fabricated by gate metal deposition and etching, or by using a lift-off metallization process. Lift-off refers to the process of patterning a masking material, e.g. photoresist, and depositing a thin film, e.g. gate metal, over the entire area, and then removing the masking material to leave behind the thin film only in the areas which were not masked.

A disadvantage of a lift-off metallization process is the possibility of unwanted metal layers and haloes remaining on the surface of the wafer after lift-off. For high voltage applications, e.g. using GaN semiconductor HEMTs, the presence of unwanted metal extrusions can cause electric field crowding and potentially lead to dielectric failure.

There is a need for improved or alternative device structures and fabrication processes for GaN HEMTs comprising field plates for high voltage applications.

### SUMMARY OF INVENTION

According to some aspects, a semiconductor device structure as defined in claim 1 and a method as defined in claim 8 are provided. The dependent claims define further implementations.

The present invention seeks to provide improved or alternative device structures and fabrication processes for GaN semiconductor power transistors, e.g. GaN HEMTs comprising field plates, which overcome one or more of the above-mentioned issues.

Aspects of the invention provide a device structure comprising a GaN semiconductor power transistor, e.g. a GaN HEMT, comprising a stepped field plate, and methods of fabrication. One aspect provides a semiconductor device structure comprising an enhancement-mode GaN semiconductor power transistor comprising:
an epitaxial layer structure comprising a semiconductor substrate, a buffer layer, a GaN semiconductor heterostructure comprising a GaN channel layer and AlGaN barrier layer providing a 2DEG active region;
a p-GaN layer patterned to define a p-GaN gate region;
a first passivation layer
contact openings through the first passivation layer for source contacts and drain contacts; ohmic contact metal within said contact openings which is patterned to form source contacts and drain contacts;
a second passivation layer;
a gate contact opening through the first and second passivation layers to the p-GaN gate region;
gate metal within the gate contact opening patterned to form a gate contact;
one or more dielectric layers extending overall;
stepped openings etched into said one or more dielectric layers for a stepped source contact, a stepped drain contact and a stepped gate field plate;
at least one layer of conductive metal filling each stepped opening and forming a stepped source contact, a stepped drain contact and a stepped gate field plate.

A thickness of the first and second passivation layers under the gate field plate, and a step size of each step of the stepped gate field plate are configured to shape an electric field under the stepped gate field plate between the gate contact and the drain contact.

The least one layer of conductive metal may comprise a single metal layer. The at least one layer of conductive metal may comprise a plurality of metal layers.

The semiconductor device structure may comprise an opening in the one or more dielectric layers for an interconnect trace connecting the source contact and the gate field plate, the opening for the interconnect trace being filled with conductive metal.

The gate metal contact may be formed by a lift-off metal process, or by deposition and etching of the gate metal. The one or more dielectric layers may comprise a plurality of dielectric layers which are etched to form the stepped openings; and the at least one layer of conductive metal comprises a plurality of metal layers filling the stepped openings to form the stepped source contact, stepped drain contact and stepped gate field plate. The one or more dielectric layers may comprise one or more etch stop layers.

Another aspect of the invention provides a method of fabricating an enhancement-mode GaN semiconductor power transistor comprising:
providing an epitaxial layer structure comprising a semiconductor substrate, a buffer layer, a GaN semiconductor heterostructure comprising a GaN channel layer and AlGaN barrier layer providing a 2DEG active region, and a blanket p-GaN layer;
etching the blanket p-GaN layer to define p-GaN gate regions;
providing a first passivation layer covering the p-GaN gate regions;
etching contact openings through the first passivation layer for source contacts and drain contacts;
depositing and patterning ohmic contact metal to form source contacts and drain contacts; providing a second passivation layer;
etching gate contact openings through the first and second passivation layers to the p-GaN gate regions;
depositing and patterning gate metal to form gate contacts;
depositing one or more dielectric layers overall;
performing a sequence of dielectric etch steps to define stepped openings for a stepped source contact, a stepped drain contact and a stepped gate field plate;
depositing at least one layer of conductive metal to fill the stepped openings and form the stepped source contact, stepped drain contact and stepped gate field plate.

The one or more dielectric layers may comprise one or more etch stop layers for creating the stepped openings.

A thickness of the first and second passivation layers under the gate field plate, and a step size of each step of the stepped gate field plate are configured to shape an electric field under the stepped gate field plate between the gate contact and the drain contact.

The step of depositing at least one layer of conductive metal may comprise depositing a single metal layer. The step of depositing at least one layer of conductive metal may comprise depositing a plurality of metal layers.

Performing the sequence of dielectric etch steps may comprise etching an opening for an interconnect trace connecting the source contact and the gate field plate, the opening for the interconnect trace being filled during the step of depositing the at least one layer of conductive metal.

Depositing and patterning gate metal to form gate contacts may comprise a lift-off metal process, or deposition and etching of the gate metal.

In some embodiments, the steps of: depositing one or more dielectric layers overall; performing a sequence of dielectric etch steps to define stepped openings for a stepped source contact, a stepped drain contact and a stepped gate field plate; and depositing at least one layer of conductive metal to fill the stepped opening and form the stepped source contact, stepped drain contact and stepped gate field plate; comprise for n=1 to N wherein N is an integer number of steps for the stepped openings: deposition of an nth dielectric layer, etching nth openings in the nth dielectric layer and deposition of an nth metal layer within the nth openings.

A GaN semiconductor power transistor structure with a stepped gate field plate and a method of fabrication is disclosed. The resulting field plate structure is less sensitive to limitations of field plates fabricated by a lift-off metal process.

### BRIEF DESCRIPTION OF THE DRAWINGS

**Fig. 1** shows a schematic cross-sectional view of a GaN HEMT device structure comprising a gate metal contact and a stepped gate metal field plate (GMFP);
**Fig. 2** shows an enlarged schematic cross-sectional view of a stepped GFMP fabricated by a lift-off process;
**Fig. 3** shows a schematic cross-sectional view of a GaN HEMT device structure of a first example embodiment comprising a stepped field plate;
**Figs 4A** to **4L** show schematic cross-sectional views to illustrate steps in a process of fabrication of the GaN HEMT structure of the first example embodiment shown in **Fig. 3****.**

The foregoing and other features, aspects and advantages will be more apparent from the following detailed description, taken in conjunction with the accompanying drawings, of example embodiments, which description is by way of example only.

### DETAILED DESCRIPTION

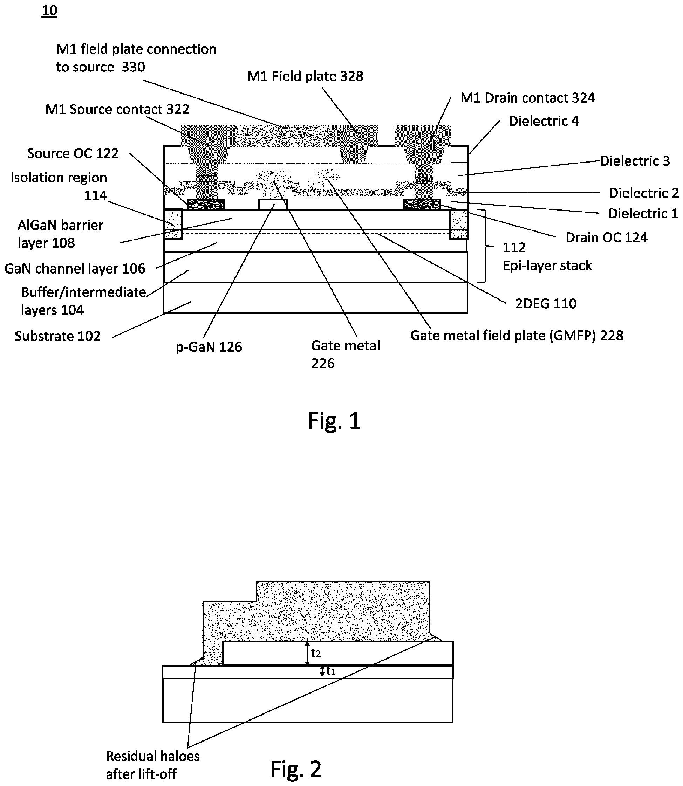

A schematic cross-sectional view of an example device structure 10 comprising an enhancement mode (E-mode) GaN HEMT with a stepped field plate is shown in **Fig. 1****.** The GaN transistor is fabricated on a semiconductor substrate, e.g. a silicon substrate 102. The semiconductor layers comprise an epitaxial layer stack 112 comprising one or more buffer layers or intermediate layers 104, a GaN channel layer 106, and an overlying AlGaN barrier layer 108, which are formed epitaxially on the semiconductor substrate 102. For example, for a GaN-on-Silicon device structure, the substrate 102 may be p-doped silicon <111>. The latter may be referred to as the growth substrate. The GaN/AlGaN heterostructure layers 106/108 create a 2DEG active area 110 in device regions of the GaN-on-Si substrate. The stack of GaN epitaxial layers that is formed on the silicon substrate, i.e. intermediate layers 104, GaN layer 106, and AlGaN layer 108, and any intervening layers not actually illustrated, will be referred to below as the "epi-layer stack" or "epi-stack" 112. After formation of the epi-layer stack 112, source, drain and gate electrodes are formed. For example, a conductive metal layer, e.g. a layer of aluminum/titanium (Al/Ti), which forms an ohmic contact (OC) with the underlying GaN heterostructure layer, is deposited to define a source electrode 122 and a drain electrode 124. A gate electrode 226 is defined over the channel region between the source and drain electrodes, e.g. a gate electrode comprising a Schottky metal, e.g. titanium (Ti) or titanium nitride (TiN). The gate metal may comprise multiple layers, e.g. a thin layer of titanium (Ti), a thin layer of platinum, and a thicker layer of gold (Au). This device structure can be fabricated as a depletion mode (D-mode) device which is normally-on, or as an enhancement mode (E-mode) device, which is normally-off. For an E-mode HEMT, the gate structure includes a p-type semiconductor layer 126 provided in the region under the gate electrode, e.g. a p-type GaN layer or p-type AlGaN layer under the gate metal 226, as illustrated schematically in **Fig. 1****.** For a D-mode HEMT, the p-GaN layer is omitted, and the gate electrode is formed directly on the AlGaN barrier layer or a MIS (Metal Insulator Semiconductor) structure where the Gate is formed by depositing suitable dielectric stack on top of the AlGaN followed by the Gate electrode formation.

As illustrated schematically in **Fig. 1****,** the lateral GaN HEMT device structure also comprises a stepped gate metal field plate (GMFP) 228. The GFMP comprises the same metal layer or layers as the gate metal., e.g. a multilayer metal comprising Ti/Pt/Au. To provide a stepped GMFP, the dielectric under the GFMP comprises a first thickness (tl) of a passivation dielectric (Dielectric 2), e.g. silicon nitride (SiN), and a second thickness (t2) of another dielectric layer (Dielectric 3), e.g. silicon dioxide (SiO₂).

There is an overlying interconnect structure comprising one or more conductive metal layers. The interconnect structure may comprise a plurality of conductive metal layers, and intervening (inter-metal) dielectric layers, to provide source, drain and gate contacts. For example, a first layer of metal, which may be referred to a contact metal provides a source contact 222 to the source OC 122 and a drain contact 224 to the drain OC 124. Another layer of metal, labelled M1, provides a larger area source contact 322 and a drain contact 324. The contact metal and metal M1 may each comprise multiple conductive metal layers or be formed from a single conductive metal layer.

For simplicity, in the GaN transistor structure illustrated in **Fig. 1****,** only a single source electrode, drain electrode and gate electrode is illustrated. Although only one transistor element is illustrated for device structure 10 in the simplified schematic cross-sectional view in **Fig. 1****,** it will be appreciated that large area, multi-island lateral GaN HEMT may be provided. In a multi-island lateral GaN HEMT, multiple transistor islands or cells are connected in parallel to form a large gate width transistor, with high current carrying capability. As illustrated schematically in **Fig. 1****,** an inactive region, or isolation region 114 may surround the 2DEG active device region. For example, the isolation region may be formed by ion implantation.

The GFMP is formed from the gate metal, which may comprise multiple metal layers, e.g. Ti/Pt/Au. To form a stepped GFMP, the dielectric under the GFMP comprises a first thickness (tl) of a first passivation dielectric, e.g. silicon nitride (SiN) and a second thickness (t2) of a second dielectric layer, e.g. silicon dioxide (SiO₂).

**Fig. 2** shows an enlarged schematic cross-sectional image of an example GFMP fabricated by a lift-off process. The GFMP comprises a gate metal such as gold, and may comprise multiple metal layers, e.g. Ti/Pt/Au. The dielectric under the GFMP comprises a first thickness t1 of a first passivation dielectric, e.g. silicon nitride (SiN) and a second thickness t2 of a second dielectric layer, e.g. silicon dioxide (SiO₂).

For GaN HEMTs having a higher 2DEG density, insufficient thicknesses of dielectric under the GFMP can lead to degradation of the dielectric, which may create a leakage path. For example, if the SiN under the GMFP is too thin, e.g. ≤100nm, this is insufficiently thick for a device having a higher 2DEG density at the AlGaN/GaN interface. By choosing the right combination of dielectric thicknesses under a stepped field plate, the electric field distribution can be optimized by suppressing the magnitude of the vertical electric field, which helps to reduce leakage, and improve the robustness and lifespan of the device. For example, the thickness t₁ of the SiN passivation layer may be increased to >100nm and <140nm and the thickness t₂ of the SiO2 layer may be reduced >160nm and <200nm.

As indicated schematically in **Fig. 2****,** when a GMFP is fabricated by a lift-off metallization process, there is a risk that residual haloes of gate metal remain at the base of the GFMP. The possibility of unwanted metal layers and haloes remaining on the wafer after lift-off is a disadvantage of a lift-off process. The presence of unwanted metal extrusions can cause electric field crowding and potentially contribute to dielectric failure.

When the gate metal 226 and GMFP 228 are formed by metal deposition and etching, the structure of the gate and GMFP can be controlled. However, some semiconductor fabrication processes do not provide the option for metal deposition and etching to provide the gate metal 226 and GMFP 228, and only provide for a lift-off gate metal process.

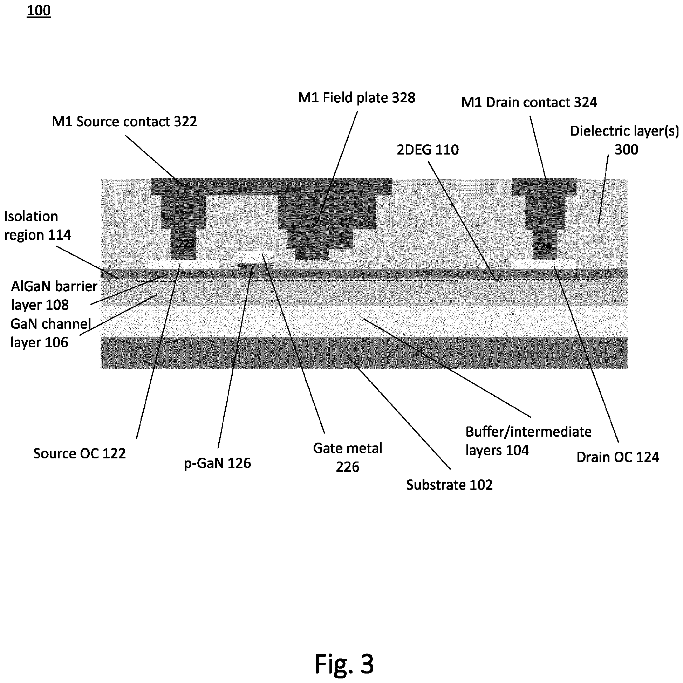

A device structure 100 comprising a GaN HEMT comprising a stepped field plate of a first example embodiment is shown in **Fig. 3****.** The device structure 100 comprises a substrate 102, e.g. a silicon substrate 102. The GaN semiconductor layers 112 comprise one or more buffer layers or intermediate layers 104, a GaN channel layer 106, and an overlying AlGaN barrier layer 108, which are formed epitaxially on the native silicon substrate 102. The latter may be referred to as the growth substrate. The GaN/AlGaN heterostructure layers 106/108 create a 2DEG active region 110 in device regions of the GaN-on-Si substrate. The stack of GaN epitaxial layers that is formed on the silicon substrate, i.e. intermediate layers 104, GaN layer 106, and AlGaN layer 108, and any intervening layers not actually illustrated, will be referred to below as the "epi-layer stack" or "epi-stack" 112. After formation of the epi-layer stack 112, source, drain and gate electrodes are formed. For example, a conductive metal layer, e.g. a layer of aluminum/titanium (Al/Ti), which forms an ohmic contact (OC) with the underlying GaN heterostructure layer, is deposited to define a source electrode 122 and a drain electrode 124. A gate electrode 126, is also defined over the channel region between the source and drain electrodes, e.g. a gate electrode comprising a Schottky metal, Ti or TiN. This device structure can be fabricated as a depletion mode (D-mode) device which is normally on, or as an enhancement mode (E-mode) device, which is normally off. For example, for a D-mode HEMT, the GaN heterostructure may comprise a layer of undoped GaN and a layer of undoped AlGaN, with the gate electrode formed directly on the AlGaN layer or a MIS (Metal Insulator Semiconductor) structure where the gate is formed by depositing suitable dielectric stack on top of the AlGaN followed by the gate electrode formation. For an enhancement mode (E-mode) HEMT, the GaN hetero-structure includes a p-type semiconductor layer 126 provided in the region under the gate electrode, e.g. p-type GaN layer or p-type AlGaN layer under the gate metal, as illustrated schematically in **Fig. 3****.**

A multi-layer interconnect structure comprises a plurality of conductive metal layers, and intervening dielectric layers, to provide source, drain and gate contacts. For example, a first layer of metal, which may be referred to as contact metal provides a source contact 222 to the source OC 122 and a drain contact 224 to the drain OC 124. Another layer of metal, labelled M1, provides a larger area source contact 322 and drain contact 324. As illustrated schematically in **Fig. 3****,** the lateral GaN HEMT device structure also comprises a stepped metal field plate (GMFP) 328. The GMFP 328 may be provided by a layer of metal M1.

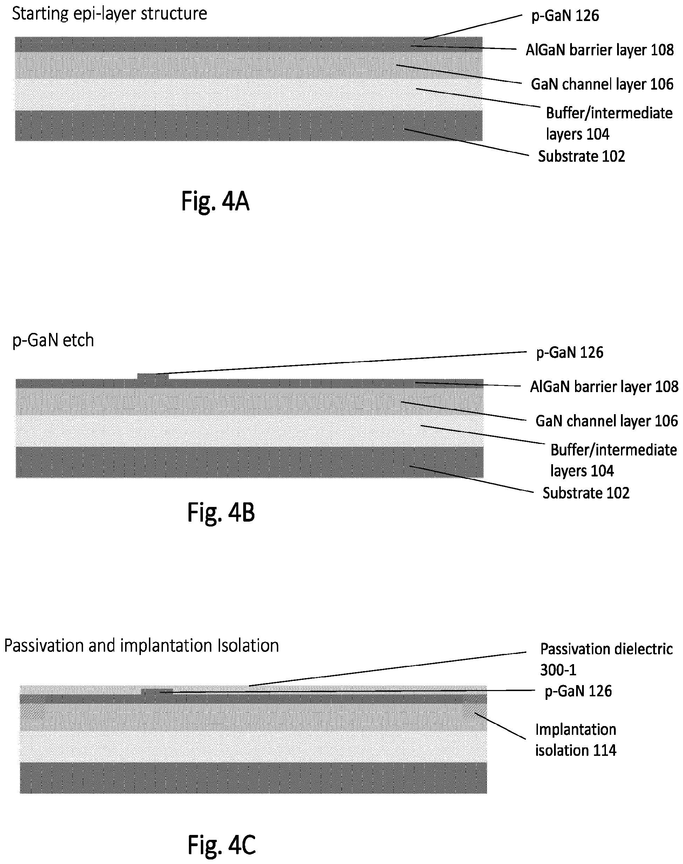

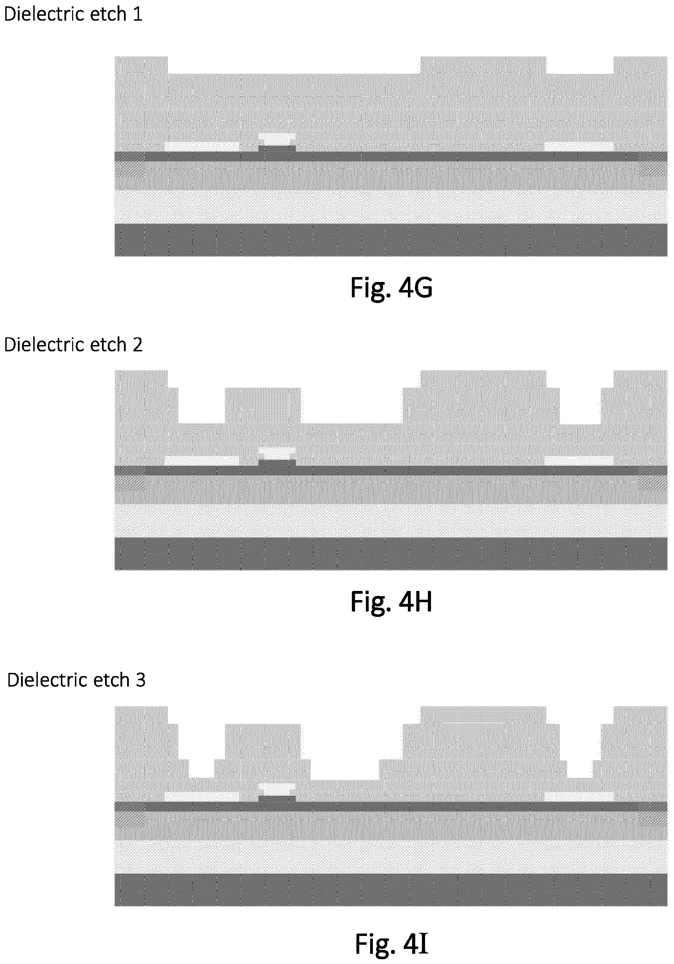

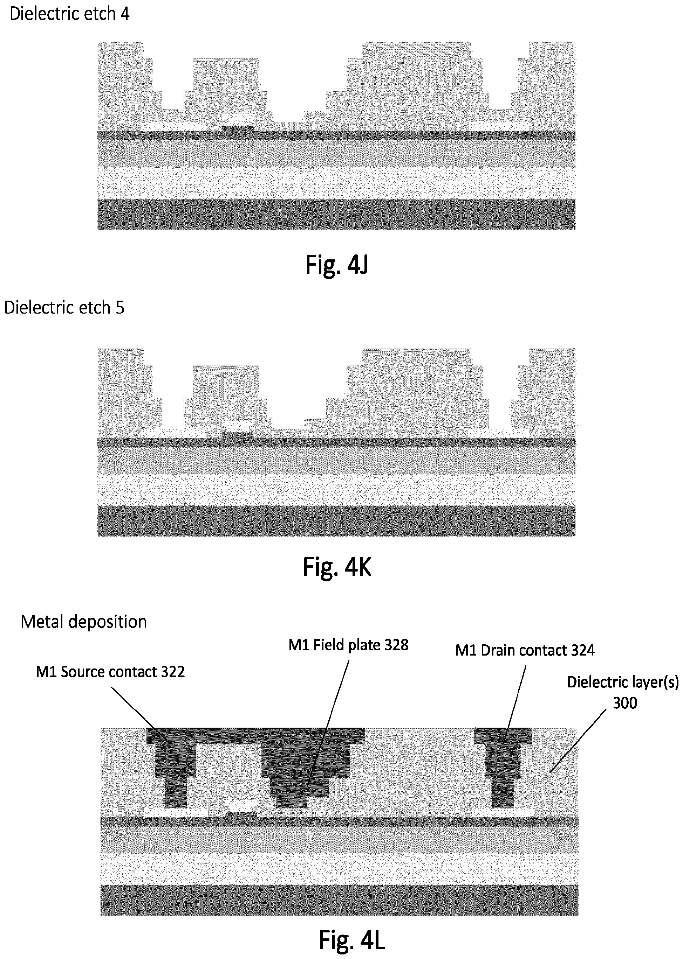

**Figs. 4A** to **4L** show schematic cross-sectional views to illustrate steps in fabrication of a GaN HEMT comprising a stepped field plate of a first example embodiment as shown in **Fig. 3****.** As illustrated schematically in **Fig. 4A****,** in fabrication of GaN HEMTs for high voltage applications, the starting wafer may be an epitaxial wafer comprising a silicon substrate 102, and a GaN semiconductor epitaxial layer stack comprising one or more buffer/intermediate layers 104, a GaN channel layer 106, and an overlying AlGaN barrier. The GaN/AlGaN heterostructure layers create a 2DEG active region for device regions of the GaN-on-Si substrate. The epitaxial layer stack for enhancement mode GaN HEMTs comprising a p-GaN gate structure may include a blanket layer of p-GaN 126. A first step in the process is a p-GaN gate etch that defines the p-GaN gate area for each transistor element, as illustrated schematically in **Fig. 4B****.** Careful control of device processing is required to maintain the micro-structural quality of the semiconductor layers of the starting wafer. For example, exposure of the semiconductor layers of AlGaN and p-GaN during device processing can create defect or trap states, which potentially lead to degradation of key static and dynamic electric parameters. As illustrated schematically in **Fig. 4C****,** it is therefore desirable to provide a passivation layer 300-1 over the p-GaN gate structures and over the AlGaN barrier layer prior to formation of ohmic contacts for the source and drain, gate metal for the gate structure and field plate. After providing the passivation layer 300-1, an isolation region 114 may be provided around the active region, e.g. an ion implantation may be performed to form isolation regions 114, surrounding the active region.

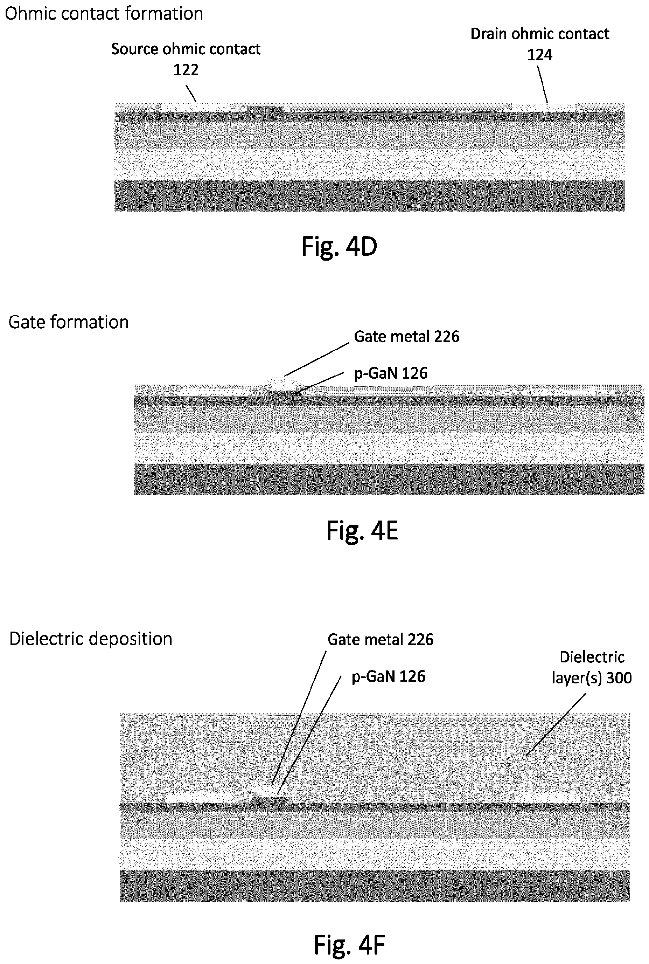

After forming the passivation layer 300-1, as illustrated schematically in **Fig. 4D****,** openings are made in the passivation layer 300-1 and a source ohmic contact 122 and a drain ohmic contact 124 are formed. After providing another dielectric layer or masking layer, a gate contact opening is made, and gate metal 226 is provided by deposition and etch back, or using a lift-off process, as illustrated in **Fig. 4E****.**

Then, as illustrated schematically in **Fig. 4F****,** one or more dielectric layers 300 are deposited to provide a required thickness of dielectric layer(s) 300. If a maximum thickness for deposition of a dielectric layer is limited, the required thickness of dielectric layer(s) 300 may comprise multiple dielectric deposition steps.

The process then proceeds with a sequence of dielectric etch steps 1 to 5 as illustrated schematically in **Figs. 4G** to **4K****.** These etch steps provide stepped openings for a source contact, a drain contact, and a stepped metal field plate. As illustrated schematically in **Fig. 4L****,** a metal M1 deposition step may be used to form an M1 source contact 322, an M1 field plate 328, and an M1 drain contact 324, resulting in the device structure as shown in **Fig. 4L****.** Depending on thickness of dielectric layers 300, it may be possible to provide a single metal deposition of M1 to form the M1 source contact 322, M1 field plate 328, and M1 drain contact 324. As illustrated schematically in **Fig. 3****,** the metal deposition may comprise multiple metal layers, e.g. deposition of a contact metal layer and deposition of one or more thicknesses of metal to build up sufficient thickness of M1.

In an alternative process flow, the stepped M1 source contact 322, stepped M1 field plate 328, and stepped M1 drain contact 324, may be provided by a sequential etch and deposition process, e.g.:
deposition of a first thickness of dielectric, etching of first contact openings, deposition of a first thickness of M1;
deposition of a second thickness of dielectric, etching of second contact openings, larger than first contact openings; deposition of a second thickness of M1; and for layer n>2, deposition of an nth thickness of dielectric, etching of nth contact openings, larger than n-1th contact openings; deposition of an nth thickness of M1, until the required interconnect structure is achieved.

These fabrication processes allow for a gate field plate to be provided by a first metal layer M1, and for the gate field plate to be sized and stepped to shape appropriately the electric field in the region between the gate and drain.

By choosing the right combination of dielectric thicknesses under a stepped field plate, the electric field distribution can be optimized by suppressing the magnitude of the vertical electric field, which helps to reduce leakage, and improve the robustness and lifespan of the device. For example, a thickness t1 of a first passivation layer, e.g. silicon nitride, may be in a range >100nm and <140nm, and a thickness t2 of the second passivation layer, e.g. SiO2 layer, may be in a range >160nm and <200nm.

The stepped gate field plate is formed using contact metal and/or interconnect metal. Typical step sizes for the field plates are hundreds of nanometres. Thus the total thickness of the one or more dielectric layers can be thin enough that only a single metal M1 can fill the stepped openings. The stepped structure of the gate field plate is defined by dielectric etching, e.g. using etch stop layers. The dielectric thickness under the stepped gate field plate can be stepped to shape appropriately the electric field in the region between the gate and drain. Alternatively double metal or multi-level metal interconnect may be used. If multi-level metal interconnect is used, the field plate can be connected to source through a second or subsequent metal layer. The source contacts and drain contacts are stepped only as needed for filling the contact opening, e.g. to accommodate for misalignment during photolithography.

Although example embodiments have been described and illustrated in detail, it is to be clearly understood that the same is by way of illustration and example only and not to be taken by way of limitation, the scope of the present invention being limited only by the appended claims.

## Claims

1. A semiconductor device structure comprising an enhancement-mode GaN semiconductor power transistor comprising:
an epitaxial layer structure comprising a semiconductor substrate, a buffer layer, a GaN semiconductor heterostructure comprising a GaN channel layer and AlGaN barrier layer providing a 2DEG active region;
a p-GaN layer patterned to define a p-GaN gate region;
a first passivation layer;
contact openings through the first passivation layer for source contacts and drain contacts;
ohmic contact metal within said contact openings which is patterned to form source contacts and drain contacts;
a second passivation layer;
a gate contact opening through the first and second passivation layers to the p-GaN gate region;
gate metal within the gate contact opening patterned to form a gate contact;
one or more dielectric layers extending overall;
openings etched into said one or more dielectric layers for a source contact, a drain contact and a stepped gate field plate;
at least one layer of conductive metal filling each of said openings and forming the source contact, the drain contact and the stepped gate field plate.

2. The semiconductor device structure of claim 1, wherein said one or more dielectric layers comprise one or more etch stop layers.

3. The semiconductor device structure of claim 1 or 2, wherein a thickness of the first and second passivation layers under the stepped gate field plate, and a step size of each step of the stepped gate field plate are configured to shape an electric field under the stepped gate field plate between the gate contact and the drain contact.

4. The semiconductor device structure of claim 1, wherein the least one layer of conductive metal comprises one of a single metal layer or a plurality of metal layers.

5. The semiconductor device structure of any one of claims 1 to 4, comprising an opening in the one or more dielectric layers for an interconnect trace connecting the source contact and the stepped gate field plate, the opening for the interconnect trace being filled with conductive metal.

6. The semiconductor device structure of any one of claims 1 to 5, wherein the gate metal contact is formed by one of a lift-off metal process or deposition and etching of the gate metal.

7. The semiconductor device structure of any one of claims 1 to 6, wherein the one or more dielectric layers comprises a plurality of dielectric layers which are etched to form the stepped openings; and the at least one layer of conductive metal comprises a plurality of metal layers filling the stepped openings to form a stepped source contact, a stepped drain contact and stepped gate field plate.

8. A method of fabricating an enhancement-mode GaN semiconductor power transistor comprising:
providing an epitaxial layer structure comprising a semiconductor substrate, a buffer layer, a GaN semiconductor heterostructure comprising a GaN channel layer and AlGaN barrier layer providing a 2DEG active region, and a blanket p-GaN layer;
etching the blanket p-GaN layer to define p-GaN gate regions;
providing a first passivation layer covering the p-GaN gate regions;
etching contact openings through the first passivation layer for a source contact and a drain contact;
depositing and patterning ohmic contact metal to form the source contact and drain contact;
providing a second passivation layer;
etching gate contact openings through the first and second passivation layers to the p-GaN gate regions;
depositing and patterning gate metal to form a gate contact;
depositing one or more dielectric layers overall;
performing a sequence of dielectric etch steps to define openings for a source contact, a drain contact and a stepped gate field plate;
depositing at least one layer of conductive metal to fill the said openings and the stepped source contact, drain contact and the stepped gate field plate.

9. The method of claim 8, wherein a thickness of the first and second passivation layers under the stepped gate field plate, and a step size of each step of the stepped gate field plate are configured to shape an electric field under the stepped gate field plate between the gate contact and the drain contact.

10. The method of claim 8 or 9, wherein the step of depositing at least one layer of conductive metal comprises one of depositing a single metal layer or depositing a plurality of metal layers.

11. The method of any one of claims 8 to 10, wherein performing the sequence of dielectric etch steps comprises etching an opening for an interconnect trace connecting the source contact and the stepped gate field plate, the opening for the interconnect trace being filled during the step of depositing the at least one layer of conductive metal.

12. The method of any one of claims 8 to 11, wherein depositing and patterning gate metal to form gate contacts comprises a lift-off metal process.

13. The method of any one of claims 8 to 12, wherein depositing and patterning gate metal to form gate contacts comprises deposition and etching of the gate metal.

14. The method of any one of claims 8 to 13, wherein the steps of:
depositing one or more dielectric layers overall; and performing a sequence of dielectric etch steps to define said openings for a source contact, a drain contact and a stepped gate field plate comprises depositing said one or more dielectric layers comprising etch stop layers for defining the stepped structure of the stepped gate field plate.

15. The method of any one of claims 8 to 14, wherein the steps of:
depositing one or more dielectric layers overall; performing a sequence of dielectric etch steps to define stepped openings for a source contact, a drain contact and a stepped gate field plate; and depositing at least one layer of conductive metal to fill the stepped opening and form the stepped source contact, stepped drain contact and stepped gate field plate; comprises, for n=1 to N wherein N is an integer number of steps for the stepped openings:
deposition of an nth dielectric layer, etching nth openings in the nth dielectric layer and deposition of an nth metal layer within the nth openings.
